# EUROPEAN PATENT APPLICATION

(11) **EP 1 067 605 A1**
(43) Date of publication of application: **10.01.2001**
(21) Application number: 99830431.5
(22) Date of filing: 05.07.1999
(51) Int. Cl.: H01L 27/115, H01L 21/8242

(54) **Ferroelectric memory cell and corresponding manufacturing method**

(71) Applicant: STMicroelectronics S.r.l., 20041 Agrate Brianza (Milano) (IT)
(72) Inventor: Casagrande, Giulio, 20060 Vignate (Milano) (IT); Zambrano, Raffaele, 95029 Catania (IT)
(74) Representative: Botti, Mario

(57) **Abstract**

A memory cell (2) integrated in a semiconductor substrate (3) and comprised of a MOS device (4) connected in series to a capacitive element (5), wherein
- the MOS device (4) has first and second conduction terminals (6),
- the capacitive element (5) has a lower electrode (16) covered with a layer (17) of a dielectric material and coupled capacitively to an upper electrode (18),
said MOS device (4) is overlaid by at least one metallization layer (10,13), which metallization layer (10,13) is covered with at least one top insulating layer (11,14), that the capacitive element (5) is formed on the top insulating layer (11,14), and that said metallization layer (10,13) extends only between said MOS device (4) and said capacitive element (5).

## Description

### Field of the Invention

This invention relates to a ferroelectric memory cell.

Specifically, the invention relates to a memory cell, integrated on a semiconductor substrate, which comprises a MOS device connected serially to a capacitive element; the MOS device comprising first and second conduction terminals, and the capacitive element comprising a lower electrode which is covered with a layer of a dielectric material and coupled capacitively to an upper electrode.

The invention further relates to a method for manufacturing at least one memory cell as above.

The invention relates, particularly but not exclusively, to a non-volatile ferroelectric memory cell, and the description to follow deals with this field of application for simplicity.

### Prior Art

Electronic memory devices, comprising ferroelectric components and integrated on a semiconductor, are known to comprise a plurality of ferroelectric memory cells organized in a matrix form; that is, the cells are laid into rows or word lines and columns or bit lines.

Each ferroelectric memory cell comprises a MOS transistor and a ferroelectric capacitor.

Known processes for manufacturing such memory cells include, once the MOS transistor is integrated in a semiconductor substrate, covering the entire chip surface with-an insulating layer.

The ferroelectric capacitor is formed on top of this insulating layer. The capacitor conventionally includes a lower electrode of metal placed onto the insulating layer.

A ferroelectric material layer covers the lower electrode, and a metal upper electrode is laid onto the ferroelectric layer.

An electrode of the ferroelectric capacitor is then connected to a conduction electrode of the MOS transistor.

After forming the ferroelectric memory cell, the next metallization layers are formed as necessary to complete the memory circuit structure.

While being advantageous in many ways, this solution has a number of drawbacks. The required treatment for the provision of metallization levels can damaged the properties of the ferroelectric materials, and with it, the performance of a ferroelectric memory cell.

A prior approach to attenuating this problem is described by Amanuma in an article "Capacitor-on-Metal/Via-stacked-Plug (CMVP) Memory Cell for 0.25µm CMOS Embedded FeRAM", incorporated hereto by this reference.

The article describes a ferroelectric memory cell comprising a MOS transistor integrated in a semiconductor, the formation of two metallization levels followed by the formation of a ferroelectric capacitor, and ultimately the formation of a final metallization layer.

Although achieving its objective, not even this solution is devoid of drawbacks. The provision of a final metallization layer after forming the ferroelectric capacitor results, in fact, in degradation of the ferroelectric material.

The underlying technical problem of this invention is to provide a ferroelectric memory cell with such construction and functional features as to retain the ferroelectric characteristics of its component materials and overcome the limitations and drawbacks that still beset prior art ferroelectric memory devices.

### Summary of the Invention

The concept behind this invention is one of providing a memory structure which comprises at least one ferroelectric memory cell consisting of a MOS transistor connected to a ferroelectric capacitor, wherein the ferroelectric capacitor is formed after all the metallization levels of the memory structure have been formed.

Based on this concept, the technical problem is solved by a ferroelectric memory cell as previously indicated and defined in the characterising portion of Claim 1.

The problem is then solved by a method as previously indicated and defined in the characterising portion of Claim 5.

The features and advantages of a device according to the invention will become apparent from the following description of an embodiment thereof, given by way of non-limitative example with reference to the accompanying drawings.

### Brief Description of the Drawings

In the drawings:
Figure 1 is an enlarged view from above showing schematically a portion of a memory matrix which comprises a plurality of the ferroelectric memory cells according to this invention;
Figure 2 is a sectional view of Figure 1 taken along line II-II;
Figure 3 is a sectional view of Figure 1 taken along line III-III;
Figure 4 is a sectional view, similar to Figure 2, of a second embodiment of the invention;
Figure 5 is a sectional view of Figure 1 taken along line III-III, also showing a first embodiment of an external contact area for the memory matrix according to the invention;
Figure 6 is a sectional view of Figure 1 taken along line III-III, also showing a second embodiment of an external contact area for the memory matrix according to the invention.

### Detailed Description

Referring to the drawing views, a ferroelectric memory cell embodying this invention will now be described.

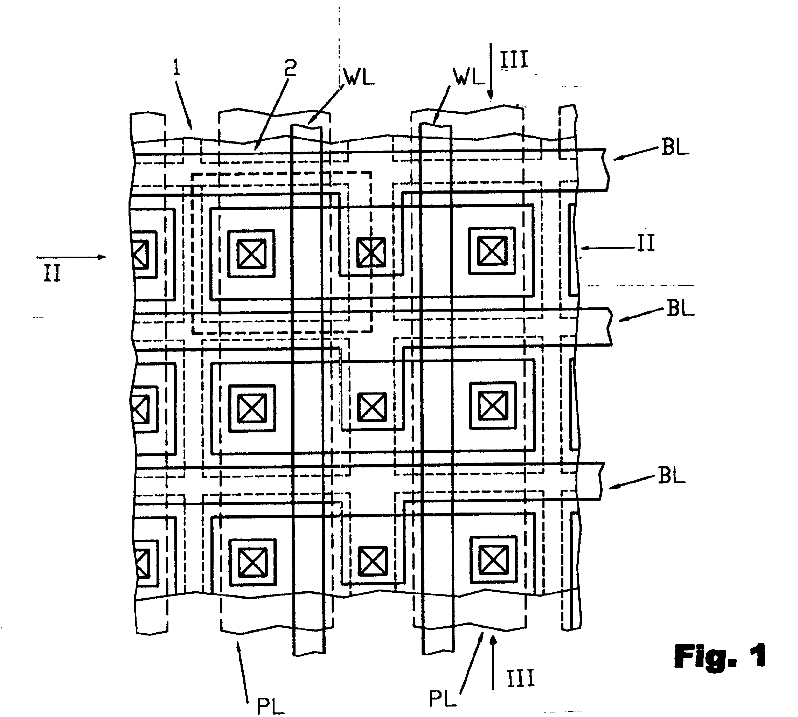

Figure 1 is an enlarged view from above showing schematically an embodiment of a portion of a memory matrix 1 comprising a plurality of non-volatile ferroelectric memory cells 2, integrated on a semiconductor substrate 3.

These cells 2 are laid into rows WL or word lines and columns BL or bit lines.

The plurality of memory cells 2 is individually pointed out by the intersections of the bit and word lines.

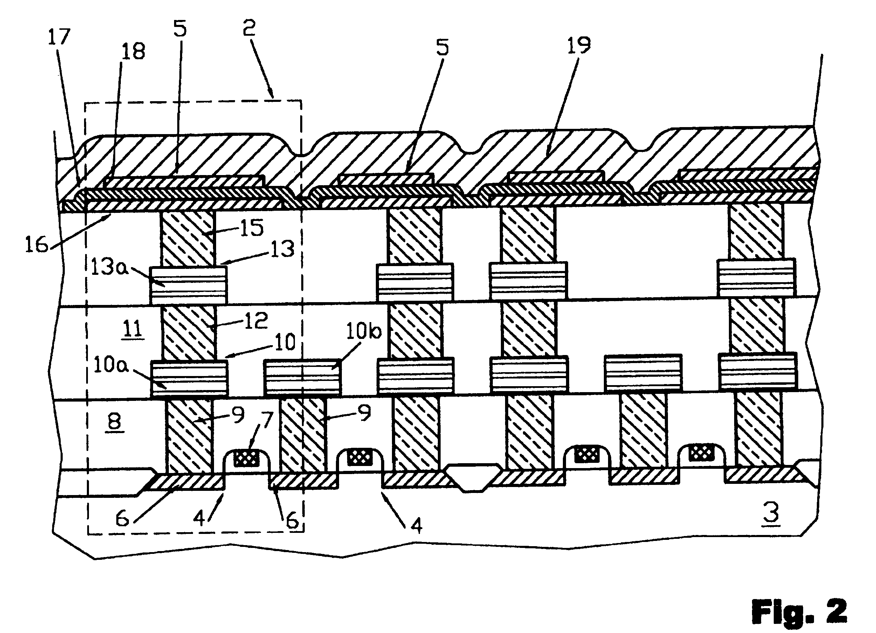

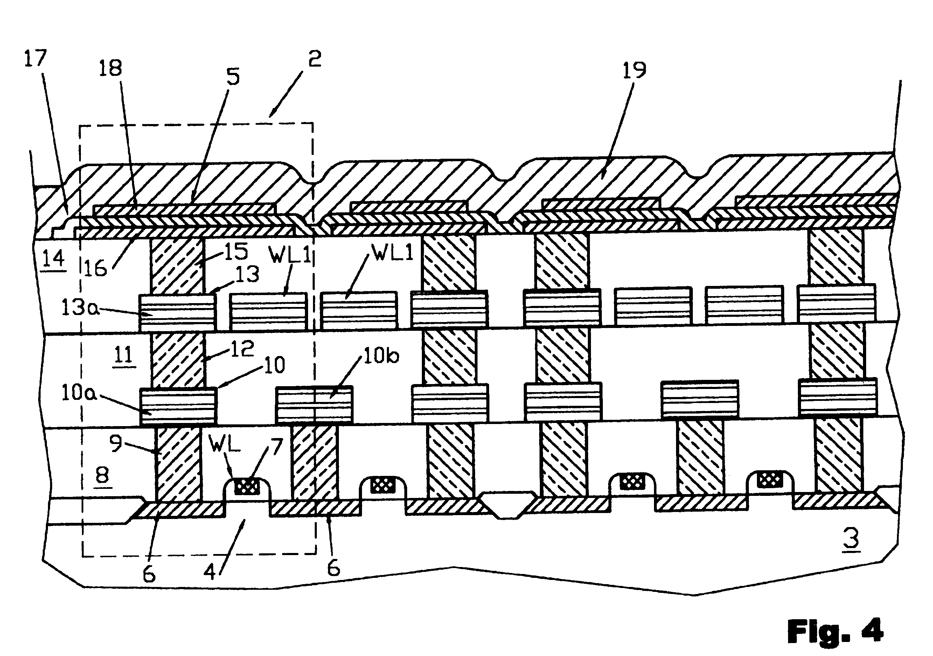

Referring to Figures 2 and 4, a plurality of ferroelectric memory cells 2 are formed on the semiconductor substrate 3.

Each ferroelectric memory cell 2 comprises, in a known manner, a MOS transistor 4 connected to a capacitive element 5.

As the skilled persons in the art know very well, each MOS transistor 4 has first and second conduction terminals 6 of the transistor 4 which are both formed in respective source and drain regions on the substrate 3.

A gate (or control) electrode 7 of polysilicon overlies the substrate region included between pairs of the conduction terminals 6, and is isolated from the substrate 3 surface by a thin oxide layer.

The gate electrodes 6 of transistors in the same row are generally formed from polysilicon and coupled to a single word line WL, also generally formed from polysilicon.

Each word line interconnects electrically the transistors 4 in the same row of the matrix 1.

In this configuration, adjacent pairs of transistors 4 in the same column BL have a conduction terminal in common.

A protective insulating layer 8, such as doped oxide with boron and phosphorus (BPSG), is then formed over the entire semiconductor surface.

Respective openings are conventionally provided through the protective insulating layer 8 aligned with the conduction terminals 6, to form respective contacts 9.

At this step, in accordance with this invention, all the metallization levels are formed as are necessary to complete the circuit structure whereto the memory device of this invention is integrated.

Thereafter, a first metallization layer 10 is formed conventionally which is then patterned to provide specified electric interconnections.

In particular, a plurality of pads 10a are formed at the contacts 9 connected to the source terminal of the transistor 4, and a plurality of pads 10b are formed at the drain of the transistor 4 for connection to a respective bit line BL.

A second protective insulating layer 11 is subsequently formed to entirely cover the semiconductor surface.

Respective openings are provided through the insulating layer 11 aligned with the pads 10a for conventionally producing respective contacts 13.

A second metallization layer 13 is formed and then patterned to provide specified electric interconnections.

In particular, a plurality of pads 13a are formed aligned with the contacts 12 connected to the source terminal of the transistor 4.

In a specially advantageous embodiment shown in Figure 4, auxiliary word lines WL1 are formed from this metallization layer 13.

These word lines WL1 are placed in contact, outside the matrix 1, with the word lines WL which connect the gate electrodes 7 of the transistors 4.

In this way, the resistance of the polysilicon word lines WL can be made lower, thereby making for faster response of the cells 2.

A third protective insulating layer 14 is subsequently formed all over the semiconductor surface.

Respective openings are provided through the insulating layer 14 aligned with the pads 13a to enable the formation of respective contacts 15, in a known manner.

According to the invention, ferroelectric capacitors 5 are provided at each MOS transistor 4.

Each ferroelectric capacitor 5 has a lower electrode 16 of metal, e.g. of platinum, placed on the insulating layer 14 at the location of a respective contact 15.

In this particular embodiment, the lower electrode 16 advantageously overlaps the control electrode 7, at least partially.

A layer 17 of a ferroelectric material covers the lower electrode 16. Preferably, the ferroelectric material layer 12 covers the entire area occupied by the memory cells.

An upper electrode 18 of metal, e.g. of platinum, is then formed on the ferroelectric material layer 17.

This upper electrode 18 is so defined as to overlap each lower electrode 16, at least partially.

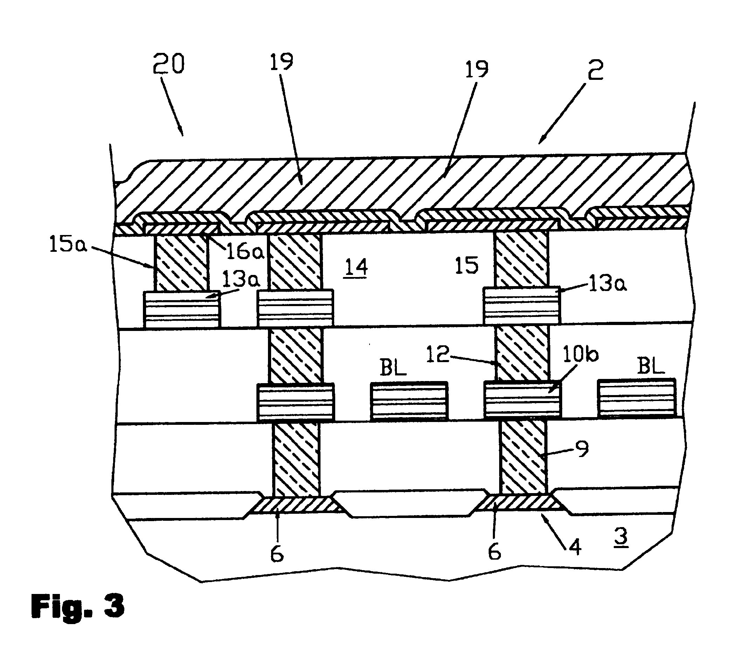

Advantageously, the upper electrodes 18 of cells 2 in the same matrix row are connected into a single line PL designated "plate line", as shown in Figure 3.

A passivating layer 19 covers the whole semiconductor surface.

In the invention, all the metallization levels are included between the MOS device and the lower electrode 16 of the capacitive element 5.

In other words, no metallization levels are provided above the electrodes of the capacitor 5.

As shown in Figure 3, an end termination 20 can be provided, outside the area of the memory matrix 1, which comprises a pad 13b formed from the second metallization layer 13.

This pad 13b is overlaid by an associated contact 15a which is surrounded by the oxide layer 14.

A flat 16a is formed, at said contact 15a, from the platinum layer that comprises the first plates 16 of the capacitor 5.

This flat 16a is then covered with the plate line PL interconnecting the upper plates 18 of the capacitors 5 in the same row of the matrix 1.

This solution allows the outputs from the memory cells (upper electrodes 18) to be driven and decoded through a metallization level provided beneath the ferroelectric capacitor 5.

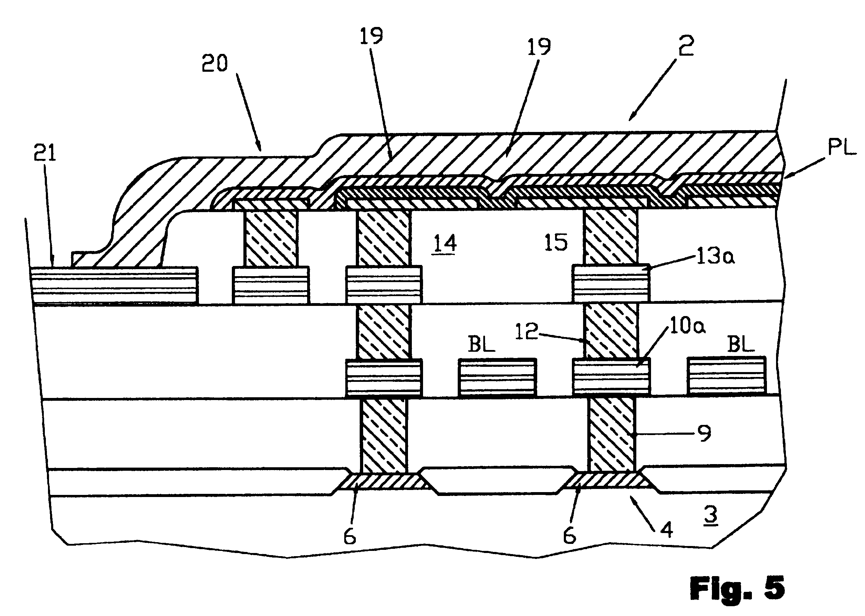

Shown in Figure 5 is a first embodiment of a possible area of connection to the output of the circuit.

In this first embodiment, a pad area 21 is formed from the second metallization level outside the matrix 1.

After the capacitors 5 are formed in the matrix 1 as previously described, the top insulating layer 14 and the passivating layer 19 are removed from a portion of the pad area 21 to provide for the connections to the output.

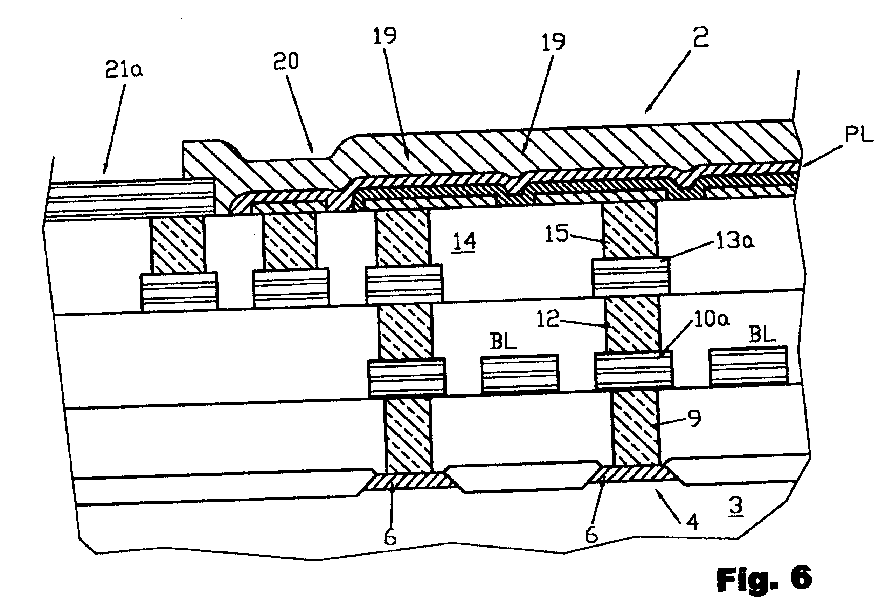

Another possible embodiment of this pad area is illustrated in Figure 6.

In particular, after forming the protective insulating layer 14, a pad area 21a is provided outside the matrix area by the formation of a further metallization layer. Once this pad area 21a is formed, the capacitors 5 are formed as previously described.

The passivation layer deposited over the entire semiconductor surface is then removed to produce the connections to the output.

In summary, the memory cell of this invention enables the ferroelectric device to be fabricated after the last metallization layer has been laid.

Thus, the problems involved in integrating the ferroelectric devices with standard CMOS fabrication processes have been reduced substantially.

## Claims

1. A memory cell (2) integrated in a semiconductor substrate (3) and comprised of a MOS device (4) connected in series to a capacitive element (5) ;
- the MOS device (4) comprising first and second conduction terminals (6);
- the capacitive element (5) comprising a lower electrode (16) covered with a layer (17) of a dielectric material and coupled capacitively to an upper electrode (18), characterised in that:
said MOS device (4) is overlaid by at least one metallization layer (10,13), said metallization layer (10,13) being covered with at least one top insulating layer (11,14), said capacitive element (5) being formed on said top insulating layer (11,14), and that said metallization layer (10,13) extends only between said MOS device (4) and said capacitive element (5).

2. A memory cell according to Claim 1, characterised in that said capacitive element (5) is a ferroelectric capacitor and the dielectric layer (17) is a ferroelectric material layer.

3. A memory cell according to Claim 1, characterised in that said memory cell (2) is a non-volatile memory cell.

4. A memory cell according to Claim 2, characterised in that the ferroelectric material layer covers the semiconductor completely in the region occupied by memory cells (2).

5. A method of fabricating at least one memory cell (2) integrated in a semiconductor substrate (3) and comprised of a MOS device (4) connected in series to a capacitive element (5) ;
- the MOS device (4) having first and second conduction terminals (6);
- the capacitive element (5) having a lower electrode (16) covered with a layer (17) of a dielectric material and coupled capacitively to an upper electrode (18) ; characterised in that it comprises the additional steps of:
- forming the MOS device (4) on the semiconductor substrate (3);
- forming a first protective layer (8) over said MOS device (4);
- forming and patterning at least one metallization layer (10,13);
- forming at least one second protective layer (11,14) over said at least one metallization layer (10,13);
- forming the lower electrode (16) of said capacitive element (5) on said at least one second protective layer (11,14) such that said at least one metallization layer (10,13) only extends between the MOS device (4) and the lower electrode (16) of the capacitive element (5).

6. A method of fabricating at least one memory cell (2) according to Claim 5, characterised in that a plurality of contact vias (9,12,15) are provided through said protective layers (9,12,15) for establishing electrical connection between the lower electrode (16) of the capacitive element (5) and at least one conduction terminal (6) of the MOS device (4).

7. A method of fabricating at least one memory cell (2) according to Claim 6, characterised in that said capacitive element (4) is a ferroelectric capacitor and the dielectric layer (17) is a ferroelectric material layer.

8. A method of fabricating at least one memory cell (2) according to any of Claim 5 to 7, characterised in that at least one first (10) and one second (13) metallization layer is formed before forming said lower electrode (16).

9. A method of fabricating at least one memory cell (2) according to Claim 8, characterised in that a pad area (21) is formed from the second metallization layer (13).

10. A method of fabricating at least one memory cell (2) according to Claim 8, characterised in that a terminating element (20) is formed from the second metallization layer and is connected to at least one electrode (16,18) of said capacitive element (5).
